# EUROPEAN PATENT APPLICATION

(11) **EP 0 905 565 A1**
(43) Date of publication of application: **31.03.1999**
(21) Application number: 98115794.4
(22) Date of filing: 21.08.1998
(51) Int. Cl.: G03F 7/09

(54) **Improved deep ultraviolet photolithography**

(30) Priority: 30.09.1997 US 940805
(71) Applicant: SIEMENS AKTIENGESELLSCHAFT, 80333 München (DE)
(72) Inventor: Lu, Zhijian, Poughkeepsie, NY 12603 (US)
(74) Representative: Patentanwälte Westphal, Mussgnug & Partner

(57) **Abstract**

Disclosed is a method for making an anti-reflective layer 202 for improving photoresist resolution and process window. The method includes providing a first volume of organic anti-reflective chemical. Providing a second volume of photo-acid generator chemical. The second volume being between about 0.01 percent and about 30 percent of the first volume. Mixing the first volume of organic anti-reflective chemical and the second volume of photo-acid generator chemical substantially simultaneously to produce an enhanced anti-reflective chemical with an increased level of acid under the exposed regions. Wherein the increase level of acid in the enhanced anti-reflective chemical minimizes the effects of acid loss from a subsequently spin-coated deep ultra-violet photoresist layer 206 at the interface of the anti-reflective coating (ARC) 202.

## Description

### BACKGROUND OF THE INVENTION

### Field of the Invention

The present relates to the manufacture of semiconductor devices. More particularly, the present invention relates to techniques for improving the resolution of photoresist development and process window in deep ultra violet photolithography.

### Description of the Related Art

In the manufacture of semiconductor integrated circuits, well known photolithographic techniques are used to pattern the various functional features on different levels of an integrated circuit chip. Generally, photolithography involves selectively exposing regions of a photoresist coated silicon wafer to a radiation pattern, and then developing the exposed photoresist in order to selectively protect regions of wafer layers, such as metallization layers, polysilicon layers, and dielectric layers from subsequent etching operations.

In general, photoresist is a radiation-sensitive material that is typically spin-coated over a selected layer of a silicon wafer. The photoresist material is classified as either positive or negative depending on how it chemically reacts to light radiation during exposure. Positive photoresist, when exposed to radiation becomes more soluble and is thus more easily removed in a development process. In contrast, negative photoresist will generally become less soluble when exposed to radiation, thereby enabling the removal of non-exposed regions. Although the traditional I-Line photolithography process works well for patterning features in the 0.35 micron technology and larger, as feature sizes in integrated circuits continue to shrink, the patterned photoresist has been exhibiting a number of resolution limitations.

To combat this problem, photolithography engineers have been implementing optics that enable the use of wavelengths that are shorter than traditional "I-line" wavelengths (*i.e*., 365 nm). As an example, a number of common photolithography processes are now implementing deep ultra-violet "DUV" wavelengths ( *e.g*., 248 nm wavelengths). As a result of implementing DUV wavelengths in the photolithography process, a number of DUV photoresists were also developed to better interact with the shorter wavelengths. The need for DUV specific photoresists became a requirement when engineers noticed that traditional photoresists used in I-line photolithography exhibit opaque optical characteristic under DUV wavelengths. Conventionally, the DUV photoresists include two primary components, a polymer resin having deprotection groups and a photo-acid generator (PAG).

When a "positive" DUV photoresist layer is selectively exposed to define integrated circuit geometries, the PAG in exposed regions of the DUV photoresist undergo a chemical decomposition and generate a strong acid. After exposure, the wafer is then moved to a hot plate where a post expose bake (PEB) will cause the generated acid to catalyze the deprotection groups in the polymer resin of the DUV photoresist. Once the deprotection groups in the polymer resin catalyze, the exposed DUV photoresist will become soluble in an aqueous base developer solution. Ideally, all of the exposed polymer resin of the DUV photoresist material that extends down to an underlayer should catalyze during the PEB operation. However, under close inspection of a number of small feature geometries, it has been observed that varying amounts of DUV photoresist will unfortunately remain at the interface of the DUV photoresist and an anti-reflective layer alter development producing well known footing and scumming effects.

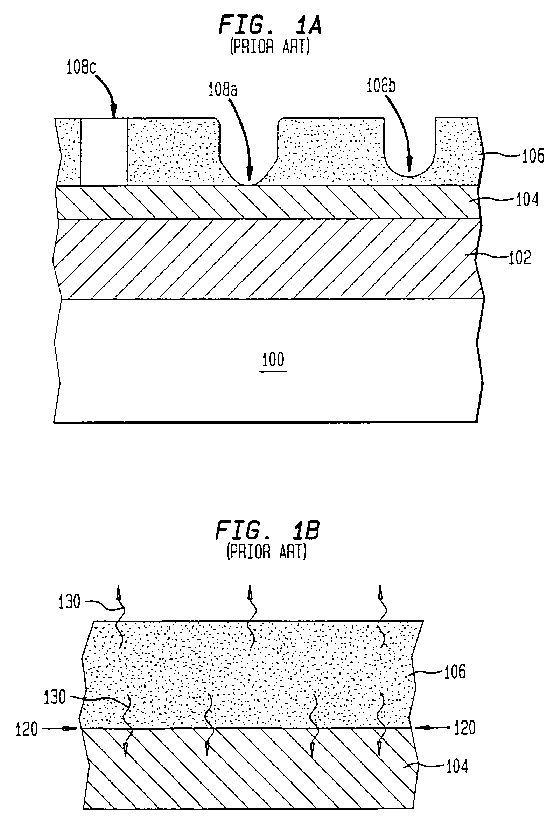

To illustrate this problem, Figure 1A shows a cross-sectional view of a semiconductor substrate 100 having a developed photoresist layer 106. The semiconductor device 100 has a layer 102 that is the target for a subsequent etching operation. A conventional bottom anti-reflective layer (BARL) 104 is typically applied over the layer 102 to aid in suppressing reflective light and to better control "critical dimensions" (CDs). Finally, a positive DUV photoresist layer 106 is spin-coated over the BARL layer 104. After a number of exemplary feature patterns are exposed through a reticle-stepper apparatus, a PEB operation is performed, and a development is performed, a poor resolution will unfortunately appear. As shown, the DUV photoresist 108 is shown having poor resolution that is a result of undeveloped photoresist material at regions 108a-108c.

One of the resulting poor resolutions is believed to occur when an acid compound of the PAG is prematurely lost. This acid loss may be attributed to a number of well known factors, including, base neutralization, evaporation, or both. In some cases, the acid loss at the interface of air and photoresist is so severe that very poor resolution occurs as illustrated by region 108c. The poor resolution is sometimes referred to as "T-top"( *i.e*., closed patterns for contact hole structures and bridged patterns for line/space structures). As a result, only surface skin of the DUV photoresist layer 106 is left at 108c.

Acid loss will also occur at an interface 120 of the BARL layer 104 and the DUV photoresist layer 106, which is illustrated in Figure 1B due to "acid diffusion"and "acid neutralization." Figure 1B therefore shows a number of acid diffusion arrow 130 that pictorially exhibit the loss of acid away from the DUV photoresist layer 106. When acid loss occurs at the interface 120, poor resolution effects referred to as "scumming" or "footing" will unfortunately occur at region 108a, and closed patterns may occur at resgion 108b.

Another reason for poor resolution is caused by poor aerial imaging that results when light is diffracted as it passes through a stepper reticle. By way of example, when 248 nm wavelengths are used in the photolithography process, features having CDs of about 175 nm will unfortunately suffer from the increased light diffraction. Consequently, a poor aerial image of light is produced over the DUV photoresist layer 106, thereby decreasing the intensity of light that is needed to generate a strong acid to catalyze the deprotection reaction near the BARL layer 104 interface 120.

Accordingly, when a substantial amount of acid loss occurs, regions near the interface of the DUV photoresist layer 106 and the anti-reflective layer 104 will not generate sufficient acid, and therefore less acid will be available to catalyze the deprotection groups of the polymer resin. Because the deprotection groups of the polymer resin are not sufficiently catalyzed, those regions of the DUV photoresist will remain in-soluble during the development stage, and regions 108a-c will remain in the developed photoresist. That is, only a part of the photoresist will become soluble during the development stage, thereby producing very poor feature resolution. Poor photoresist resolution is particularly problematic in view of continued demands for smaller integrated circuit feature sees.

In view of the foregoing, there is a need for methods and apparatus for decreasing acid loss in DUV photoresists to prevent resolution defects in the photolithography process.

### SUMMARY OF THE INVENTION

Broadly speaking, the present invention fills these needs by providing an enhanced anti-reflective layer that includes a predetermined amount of photo-acid generator (PAG) that is configured to off-set the DUV photoresist acid loss and insufficient light exposure. It should be appreciated that the present invention can be implemented in numerous ways, including as a process, an apparatus, a system, a device, or a method. Several inventive embodiments of the present invention are described below.

In one embodiment, a method for making an anti-reflective layer for improving photoresist resolution and process window is disclosed. The method includes providing a first volume of organic anti-reflective chemical. Providing a second volume of photo-acid generator chemical. The second volume being between about 0.01 percent and about 30 percent of the first volume. Mixing the first volume of organic anti-reflective chemical and the second volume of photo-acid generator chemical substantially simultaneously to produce an enhanced anti-reflective chemical with an increased level of acid.

In another embodiment, a deep ultra-violet photolithography layered structure is disclosed. The layered structure includes a base layer that is selected for patterning. An enhanced anti-reflective layer that is composed of an organic polymer and a predetermined amount of added photo-acid generator. The layered structure also includes a deep ultra-violet photoresist overlying the enhanced anti-reflective layer. The deep ultra-violet photoresist includes a photo-acid generator component and an organic polymer resin component.

In yet another embodiment, a system for generating an anti-reflective layer for improving deep ultra-violet photoresist imaging and resolution is disclosed. The system includes providing a first volume of organic anti-reflective chemical. Providing a second volume of photo-acid generator chemical. The second volume being between about 0.1 percent and about 12 percent of the first volume. Means for mixing the first volume of organic anti-reflective chemical and the second volume of photo-acid generator chemical to produce an enhanced anti-reflective chemical with an increased level of acid.

Advantageously, the aforementioned problems of photoresist footing and scumming are substantially eliminated due to the addition of a percentage of photo-acid generator into the organic polymer anti-reflective layer. As such, because more acid will be generated at the interface of the photoresist and the bottom anti-reflective layer, a much wider process window may be achieved, especially when under exposure conditions are present. Other aspects and advantages of the invention will become apparent from the following detailed description, taken in conjunction with the accompanying drawings, illustrating by way of example the principles of the invention.

### BRIEF DESCRIPTION OF THE DRAWINGS

The present invention will be readily understood by the following detailed description in conjunction with the accompanying drawings, wherein like reference numerals designate like structural elements.
Figures 1A and 1B show cross-sectional views of a semiconductor substrate having a developed photoresist layer, and the drawbacks of conventional DUV photolithography.
Figure 2 shows a cross-sectional view of a semiconductor substrate having an overlying layer in accordance with one embodiment of the present invention.
Figure 3 shows the cross-sectional view of Figure 2 alter an enhanced anti-reflective layer has been applied over the layer in accordance with one embodiment of the present invention.
Figure 4 shows the cross-sectional view of Figure 3 after a DUV photoresist layer has been spin-coated over the enhanced anti-reflective layer in accordance with one embodiment of the present invention.
Figure 5 shows the cross-sectional view of Figure 4 after the exposed DUV photoresist layer has been developed in accordance with one embodiment of the present invention.
Figure 6 is a flowchart diagram illustrating the preferred method operations in accordance with one embodiment of the present invention.

### DETAILED DESCRIPTION OF THE EMBODIMENTS

An invention for a method for improving DUV photoresist resolution by providing an enhanced anti-reflective layer that is configured to off-set DUV photoresist acid loss is disclosed. In the following description, numerous specific details are set forth in order to provide a thorough understanding of the present invention. It will be understood, however, to one skilled in the art, that the present invention may be practiced without some or all of these specific details. In other instances, well known process operations have not been described in detall in order not to unnecessarily obscure the present invention

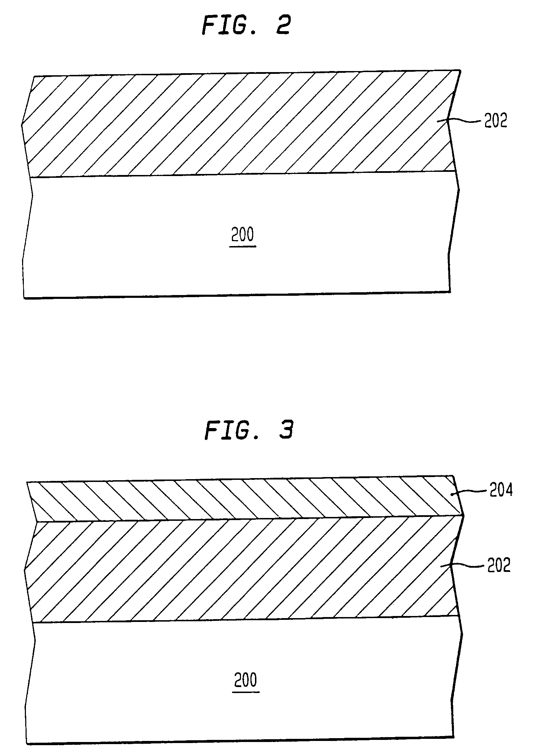

Figure 2 shows a cross-sectional view of a semiconductor substrate 200 having an overlying layer 102 in accordance with one embodiment of the present invention. In one embodiment, semiconductor substrate 200 may be a portion of a silicon wafer, such as those commonly used in the fabrication of integrated circuits (ICs). Such ICs include random access memories (RAMs), dynamic random access memories (DRAMs), synchronous DRAMs (SDRAMs), and read only memories (ROMs). ICs such as application specific integrated circuits (ASICs), merge DRAM-logic (embedded DRAM) ICs or other logic circuits can also be fabricated. Typically, a plurality of ICs are formed on the wafer in parallel. After processing is finish, the wafer is diced to separate the ICs to individual chips. The chips are then packaged, resulting in a final product that is used in, for example, consumer products such as computer systems, cellular phones, personal digital assistants (PDAs), and other electronic products. The layer 202 may be any fabricated layer that may be deposited, sputtered, formed or applied to over the semiconductor substrate 200. In this example, the layer 202 is preferably well suited for patterning to define features of an integrated circuit design.

By way of example, layer 200 may be a dielectric layer, such as a silicon dioxide (SiO₂) layer that acts as an insulator between successive metallization layers. Layer 202 may also be aluminum, copper, or polysilicon which is commonly used to define transistor gates in a semiconductor circuit design. Accordingly, layer 202 should be understood to be any layer in an integrated circuit design that may require subsequent patterning through the use of a number of well known etching techniques. Figure 3 shows the cross-sectional view of Figure 2 after an enhanced anti-reflective layer 204 has been applied over the layer 202 in accordance with one embodiment of the present invention. In one embodiment, the enhanced anti-reflective layer comprises photo-acid generator (PAG). The PAG generates acids during exposure, thereby increasing the acid concentration sufficiently at the interface of the resist bottom and ARC to compensate for acid loss in the interface and/or insufficient exposure. As a result, the acid combined with suitable bake temperature catalyzes the deprotection reaction of polymers, causing the polymers to be soluble in the base developer.

The enhanced anti-reflective layer 204 is preferably a layer that is spin-coated in a similar manner as conventional organic anti-reflective layers are applied. Other suitable techniques of depositing the enhanced anti-reflective are also useful. The enhanced anti-reflective compound is provided by, for example, mixing an organic polymer liquid used to form an anti-reflective layer 204 with PAG. The amount of PAG is sufficient, when activated, to increase the concentration of acid in the enhanced anti-reflective layer to compensate for acid loss or insufficient acid. Insufficient amounts of acid cause, for example, resist footing. By way of example, the organic polymer that makes up the enhanced anti-reflective layer 204 is mixed with between about 0.01 percent and about 30 percent (all percentages are by volume, unless noted otherwise). PAG of the organic polymer's volume, and more preferably between about 0.1 percent and about 6 percent PAG of the organic polymer's volume, and most preferably about 1 percent PAG of the organic polymer's volume. In this manner, the enhanced anti-reflective layer 204 will have an increased PAG acid concentration that will advantageously limit the amount of acid that may diffuse from a subsequently deposited DUV photoresist layer.

In general, the PAG that is added to the organic polymer will preferably be substantially stable during high thermal process steps that are typically performed as part of post-apply bake (PAB) and post-exposed bake (PEB) operations. By way of example, because a percentage of PAG will actually be present in the enhanced anti-reflective layer 204, it is important that it remain stable (*i.e*., it will not decompose) during the PAB and PEB temperatures. In one embodiment, a suitably stable PAG compound is preferably a Diphenyliodonium Salt or other well known PAG compounds.

Generally, the PAB temperatures will range between about 80 degrees Celsius and about 150 degrees Celsius, and will most preferably be about 100 degrees Celsius. The PEB temperatures generally range between about 90 degrees Celsius and about 150 degrees Celsius, and will most preferably be about 135 degrees Celsius. Under these process conditions, the PAG component should remain thermally stable and should not react with the organic polymer of the enhanced anti-reflective layer 204.

In this embodiment, a preferred thickness for the enhanced anti-reflective layer 204 is between about 300 angstroms and about 2,000 angstroms, and more preferably between about 500 angstroms and about 900 angstroms, and most preferably about 1,000 angstroms.

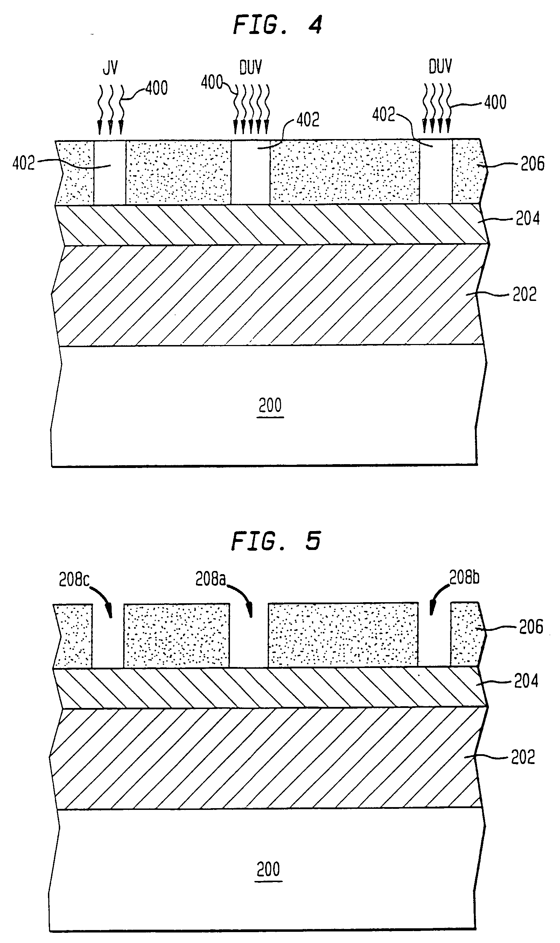

Figure 4 shows the cross-sectional view of Figure 3 after a DUV photoresist layer 206 has been spin-coated over the enhanced anti-reflective layer 204 in accordance with one embodiment of the present invention. Although specific examples and advantages are specifically described with reference to "positive"photoresists, it should be understood that the embodiments of the present invention may also be applied to "negative" photoresists. In this example, the DUV photoresist is a "positive" photoresist which may be a "UV ₂HS", "UV ₄HS", "UV ₆HS" or any other suitable positive photoresist having a polymer resin component (i.e., as a matrix) and a photo-acid generator PAG) component. These exemplary photoresists may be obtained from Shipley Co., of Marlborough, MA. In this embodiment, the DUV photoresist layer 206 is preferably spin coated to a thickness of between about 4,000 angstroms and about 15,000 angstroms, and more preferably between about 6,000 angstroms and about 7,000 angstroms, and most preferably about 6,500 angstroms.

Once the DUV photoresist layer 206 has been applied over the enhanced anti-reflective layer 204, the wafer is preferably subjected to a post-apply bake (PAB) on a hot plate to drive the solvent and ensure that the photoresist material is sufficiently hard before being exposed. Once the PAB is complete, the wafer is moved to a stepper apparatus, which is used to expose selected portions of the DUV photoresist layer 206 to DUV wavelength (*e.g*., 248 nm or 193 nm) light 400. Typically, the stepper apparatus has a reticle that includes the desired patterns that are to be transferred onto the DUV photoresist layer 206 with the aid of DUV wavelength light 400. When the DUV photoresist layer 206 is exposed, the exposed regions generate a strong acid 402.

Because the enhanced anti-reflective layer 204 contains a percentage of PAG, those regions of the DUV photoresist layer 206 that are at the interface with the enhanced anti-reflective layer 204 will have a relatively high concentration of acid, thereby effectively countering acid diffusion effects and poor aerial image. Accordingly, because more acid is generated at this interface, the scumming and footing may no longer be present in the developed DUV photoresist layer 206. At this point, the semiconductor wafer is moved onto a hot plate where a post-exposure bake (PEB) is performed at a temperature of between about 150 degrees Celsius and about 250 degrees Celsius, which causes the strong acid 402 to catalyze deep protection groups of the polymer resin that are contained in the DUV photoresist layer 206.

Advantageously, because the DUV photoresist layer 206 retains substantially more of its PAG, the deprotection groups of the polymer resin catalyze much more uniformly down to the underlying enhanced anti-reflective layer 204. After the PEB temperatures assisted the strong acid 402 in catalyzing the deprotection groups in the polymer resin of the DUV photoresist layer 206, those exposed portions of the DUV photoresist layer 206 will now become "soluble" to a developer, which is typically an aqueous base solution.

Once the developer is applied, the DUV photoresist layer 206 will have developed regions 208a-208b that extend substantially down to the enhanced anti-reflective layer 204, as shown in Figure 5. As mentioned above, by including a percentage of PAG into the enhanced anti-reflective layer 204, diffusion of acid out of the DUV photoresist layer 206 and to the underlying enhanced anti-reflective layer 204 will be substantially reduced. That is, although some acid diffusion is still present, the acid loss problem will be substantially eliminated. As such, the problematic resolution issues created by acid loss are substantially cured, thereby enabling the fabrication of photoresist masks that provide improved aspect ratios.

As compared to prior art techniques, it should be noted that thefooting effects, and scumming effects described with reference to Figure 1A may no longer be present in the developed DUV photoresist layer 206. Accordingly, it is now possible to have improved process windows, and much better control over critical dimensions (CDs) in the fabrication of integrated circuit designs. Most importantly, as features sizes continue to shrink, there will be a continued need to have improve photoresists and anti-reflective layers to achieve better imaging resolution.

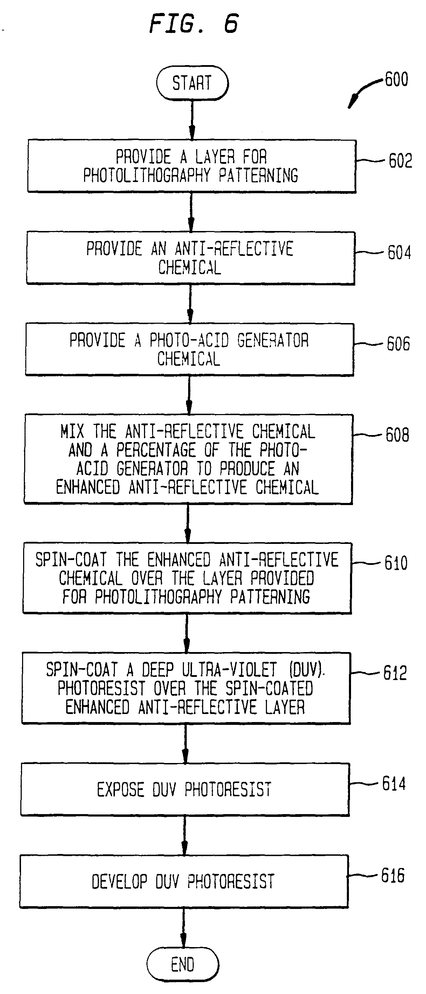

Figure 6 is a flowchart diagram illustrating the preferred method operations in accordance with one embodiment of the present invention. The method begins at an operation 602 where a layer is provided for photolithography patterning. As described above, the layer may be any layer such as an oxide layer, a metallization layer, silicon layer, polysilicon layer, etc. As is well known, these layers are commonly patterned to form numerous features that make up integrated circuit designs that are fabricated to make semiconductor chips.

Once the layer is provided in operation 602, the method proceeds to an operation 604 where an anti-reflective chemical is provided. Preferably, the anti-reflective chemical is an organic polymer which is typically used as a bottom anti-reflective layer (BARL). Once the anti-reflective chemical is provided in operation 604, the method proceeds to an operation 606 where a photo-acid generator (PAG) chemical is provided. As mentioned earlier, the PAG is preferably a Diphenyliodonium Salt or other suitable PAG compound that is thermally stable during the bake operations and does not react with the polymer of the anti-reflective layer.

The method then proceeds to an operation 608 where the anti-reflective chemical and a percentage of the PAG is substantially simultaneously mixed to produce an enhance anti-reflective chemical. Preferably, a percentage of between about 0.01% and about 30% PAG of the volume of the anti-reflective chemical is provided to produce the enhanced anti-reflective chemical. Once the enhanced anti-reflective chemical is produced, the method proceeds to an operation 606 where the enhanced anti-reflective chemical is spin-coated over the layer provided for photolithography patterning in operation 602. Preferably, the enhanced anti-reflective layer will have a thickness of between about 300 angstroms and about 2,000 angstroms.

Next, the method proceeds to an operation 612 where a deep ultra-violet (DUV) photoresist is applied over the spin-coated enhanced anti-reflective layer as described above. Preferably, the spin coated DUV photoresist has a thickness of between about 4,000 angstrom and about 15,000 angstroms. Once the DUV photoresist layer has been spin-coated in operation 612, the wafer on which the DUV photoresist is spin-coated is placed on a hot plate to perform a post-apply bake (PAB), such that the DUV photoresist hardens. The method then proceeds to an operation 614 where selected regions of the DUV photoresist are exposed.

Once exposed, the exposed regions will produce a strong acid that will assist in catalyzing the deprotection groups of the polymer resin of the DUV photoresist layer when the exposed DUV photoresist layer is subjected to a post-exposed bake (PEB). The method then proceeds to an operation 616 where the DUV photoresist is developed in an aqueous base solution that substantiallly removes all exposed regions of the DUV photoresist.

Although the foregoing invention has been described in some detail for purposes of clarity of understanding, it will be apparent that certain changes and modifications may be practiced within the scope of the appended claims. By way of example, the various improved photolithography techniques may find application in technologies that implement chemical amplified photoresists. Such technologies generally include semiconductor integrated circuits, such as logic and memory devices (*i.e*., ROM, RAM, DRAM, etc.). Accordingly, the present embodiments are to be considered as illustrative and not restrictive, and the invention is not to be limited to the details given herein, but may be modified within the scope and equivalent of the appended claims.

## Claims

1. A method for making an anti-reflective layer for improving photoresist resolution and process window, comprising:
providing a first volume of organic anti-reflective chemical;
providing a second volume of photo-acid generator chemical, the second volume being between about 0.01 percent and about 30 percent of the first volume;
mixing the first volume of organic anti-reflective chemical and the second volume of photo-acid generator chemical substantially simultaneously to produce an enhanced anti-reflective chemical with an increased level of acid.

2. A method for making an anti-reflective layer for improving photoresist resolution and process window as recited in claim 1, wherein the photo-acid generator is thermally stable.

3. A method for making an anti-reflective layer for improving photoresist resolution and process window as recited in claim 2, further comprising:
spin-coating the enhanced anti-reflective chemical over a layer that is selected to be patterned, the spin-coating being configured to produce an enhanced anti-reflective layer.

4. A method for making an anti-reflective layer for improving photoresist resolution and process window as recited in claim 3, further comprising:
spin-coating a deep ultra-violet photoresist layer over the spin-coated enhanced anti-reflective layer, the deep ultra-violet photoresist layer includes an organic polymer resin component and a photo-acid generator component.

5. A method for making an anti-reflective layer for improving photoresist resolution and process window as recited in claim 4, wherein the organic polymer resin includes deprotection groups.

6. A method for making an anti-reflective layer for improving photoresist resolution and process window as recited in claim 5, wherein the increased level of acid of the enhanced anti-reflective layer substantially reduces diffusion of the photo-acid generator component and acid of the deep ultra-violet photoresist layer into the enhanced anti-reflective layer.

7. A method for making an anti-reflective layer for improving photoresist resolution and process window as recited in claim 6, wherein the deep ultra-violet photoresist layer is a positive photoresist.

8. A method for making an anti-reflective layer for improving photoresist resolution and process window as recited in claim 7, further comprising:
exposing a light energy onto selected regions of the deep ultra-violet photoresist layer, the exposed regions being configured to produce a strong acid.

9. A method for making an anti-reflective layer for improving photoresist resolution and process window as recited in claim 8, further comprising:
subjecting the produced strong acid to a post-expose bake temperature ranging between about 90 degrees Celsius and about 150 degrees Celsius, the post-expose bake temperature being configured to cause the strong acid to catalyze the deprotection groups of the organic polymer resin.

10. A method for making an anti-reflective layer for improving photoresist resolution and process window as recited in claim 9, wherein the light energy has wavelengths of between about 248 nm and 193 nm.

11. A deep ultra-violet photolithography layered structure, comprising:
a base layer that is selected for patterning;
an enhanced anti-reflective layer that is composed of an organic polymer and a predetermined amount of added photo-acid generator; and
a deep ultra-violet photoresist overlying the enhanced anti-reflective layer, the deep ultra-violet photoresist includes a photo-acid generator component and an organic polymer resin component.

12. A deep ultra-violet photolithography layered structure as recited in claim 11, wherein the organic polymer resin component includes deprotection groups.

13. A deep ultra-violet photolithography layered structure as recited in claim 12, wherein the predetermined amount of added photo-acid generator is between about 0.01 percent and about 30 percent of the organic polymer.

14. A deep ultra-violet photolithography layered structure as recited in claim 12, wherein the predetermined amount of added photo-acid generator is between about 0.1 percent and about 6 percent of the organic polymer.

15. A deep ultra-violet photolithography layered structure as recited in claim 14, wherein the enhanced anti-reflective layer is between about 300 angstroms and about 2,000 angstroms.

16. A deep ultra-violet photolithography layered structure as recited in claim 14, wherein the deep ultra-violet photoresist has a thickness of between about 4,000 angstroms and about 15,000 angstroms.

17. A deep ultra-violet photolithography layered structure as recited in claim 16, wherein a deep ultra-violet wavelength selected from a 248 nm wavelength and a 193 nm wavelength is used to generate a strong acid in exposed regions of the deep ultra-violet photoresist.

18. A deep ultra-violet photolithography layered structure as recited in claim 17, wherein a hot plate is used to heat the generated strong acid of the exposed regions, the heat being configured to catalyze the deprotection groups of the organic polymer resin component.

19. A deep ultra-violet photolithography layered structure as recited in claim 18, wherein the deprotection groups of the organic polymer catalyze down to the base layer that is selected for patterning, such that scumming and footing is eliminated after a photoresist development stage is complete.

20. A system for generating an anti-reflective layer for improving deep ultra-violet photoresist imaging resolution and process window, comprising:
providing a first volume of organic anti-reflective chemical;
providing a second volume of photo-acid generator chemical, the second volume being between about 0.01 percent and about 12 percent of the first volume;
means for mixing the first volume of organic anti-reflective chemical and the second volume of photo-acid generator chemical to produce an enhanced anti-reflective chemical with an increased level of acid.

21. A system for generating an anti-reflective layer for improving deep ultra-violet photoresist imaging resolution and process window as recited in claim 20, further comprising:
spin-coating the enhanced anti-reflective chemical over a base layer that is selected to be patterned, the spin-coating being configured to produce an enhanced anti-reflective layer; and
spin-coating a deep ultra-violet photoresist layer over the spin-coated enhanced anti-reflective layer, the deep ultra-violet photoresist layer includes an organic polymer resin component and a photo-acid generator component.

22. A system for generating an anti-reflective layer for improving deep ultra-violet photoresist imaging resolution and process window as recited in claim as recited in claim 21, wherein the organic polymer resin includes deprotection groups.

23. A system for generating an anti-reflective layer for improving deep ultra-violet photoresist imaging resolution and process window as recited in claim 22, wherein the increased level of acid of the enhanced anti-reflective layer substantially reduces diffusion of the photo-acid generator component and acid of the deep ultra-violet photoresist layer into the enhanced anti-reflective layer.

24. A system for generating an anti-reflective layer for improving deep ultra-violet photoresist imaging resolution, and process window as recited in claim 22, wherein a developing time and developer is reduced.

25. A system for generating an anti-reflective layer for improving deep ultra-violet photoresist imaging resolution, and process window as recited in claim 22, wherein a substrate contaminating effect that poisons the deep ultra-violet photoresist layer is minimized.
